(19) Europäisches Patentamt

European Patent Office

Office européen des brevets

(11) EP 1 314 992 A2

(12) EUROPEAN PATENT APPLICATION

(43) Date of publication:
28.05.2003 Bulletin 2003/22

(51) Int Cl.$^7$: **G01R 31/36**

(21) Application number: 02024459.6

(22) Date of filing: 29.10.2002

| | |
|---|---|
| (84) Designated Contracting States:<br>**AT BE BG CH CY CZ DE DK EE ES FI FR GB GR IE IT LI LU MC NL PT SE SK TR**<br>Designated Extension States:<br>**AL LT LV MK RO SI**<br><br>(30) Priority: **30.10.2001 JP 2001333426**<br> **15.10.2002 JP 2002300785** | (71) Applicant: **YAMAHA HATSUDOKI KABUSHIKI KAISHA**<br>**Iwata-shi Shizuoka-ken (JP)**<br><br>(72) Inventor: **Oohori, Noriko**<br>**Iwata-shi, Shizuoka-ken (JP)**<br><br>(74) Representative: **Grünecker, Kinkeldey, Stockmair & Schwanhäusser Anwaltssozietät**<br>**Maximilianstrasse 58**<br>**80538 München (DE)** |

(54) **Method and device for controlling a capacity of a battery for vehicles**

(57)    Method for controlling a capacity of a battery, wherein a relative capacity is determined corresponding to an open voltage obtained from the battery in a no-load condition, and wherein a total real capacity is calculated based on the relative capacity and based on an amount of integrated discharge current of said battery

FIG. 1

EP 1 314 992 A2

**Description**

The present invention relates to a method and a device for controlling a capacity of a battery. The present invention further relates to a capacity control device of a battery for vehicle power.

In particular, the invention refers to a battery capacity control method and device for controlling the capacity of a battery, and a capacity control device of a battery for vehicle power that is mounted on a vehicle as a power member.

In a vehicle, such as a motor-driven vehicle or a hybrid one, utilizing a battery as a power source, the possible travelling distance depends on the capacity of a battery. Therefore, even if the battery is deteriorated due to repeated charging and discharging, it is necessary to determine an exact residual capacity of the battery.

Several methods have been suggested as systems for estimating the residual capacity of a battery, and for example, in Japanese Unexamined Patent Publication Hei 6-331714 (JP-A-6-331714) and Japanese Unexamined Patent Publication Hei 11-135159 (JP-A-11-135159) there is disclosed a method in which the residual capacity is estimated from a terminal voltage during the time of no-load condition, and an error of the measured residual capacity is corrected by time-integration of the charging and the discharging current.

With the known method, it is possible to determine how much the battery is charged (as the relative capacity of a battery) when the full-charged battery condition is to be 100 percent and the full-discharged battery condition is to be 0 percent. However, it is impossible to determine the possible discharge capacity of a battery subjected repeated charging and discharging, that is, a total real capacity. For example, if the total real capacity can be determined, deterioration of the total battery can be found, but this is impossible in the known method.

Further, a method is known as the method of determining the total real capacity of a battery subjected repeated charging and discharging, in which a battery is completely discharged once, followed by recharging up to a full-charge condition, and the total real capacity is determined from the total amount of charging at that time. However, this method raises a problem that it takes a lot of time and labor to discharge a battery completely, and if the battery is discharged completely, the vehicle is not available during recharging of the battery.

In view of the foregoing, it is an objective of the invention to provide a method and a device for controlling a capacity of a battery capable of easily determining a total real capacity of a battery subjected to repeated charging and discharging.

With respect to the method aspect, this objective is solved by a method for controlling a capacity of a battery, wherein a relative capacity is determined corresponding to an open voltage obtained from the battery in a no-load condition, and wherein a total real capacity is calculated based on the relative capacity and based on an amount of integrated discharge current of said battery.

Thus, a relative capacity is determined corresponding to an open voltage obtained from a battery in a no-load condition, and a total real capacity is calculated, based on the relative capacity and an amount of integrated discharge current of said battery.

According to a preferred embodiment of the present method for controlling a capacity of a battery, the relative capacity of the battery is uniquely determined from the open voltage of the battery after discharging.

Here, a relation is established in which a relative capacity of a battery is uniquely determined from an open voltage of the battery after discharging, therefore the relative capacity is obtained from the open voltage using this relation, and the total real capacity is calculated, based on the relative capacity.

It is further preferable if the amount of integrated discharge current of said battery is obtained by time-integration during the time of a load condition before no-load condition is reached.

According to a further preferred embodiment, said amount of integrated discharge current is a time-integrated value of the discharge current discharged from the condition of full-charge of said battery

Therefore, in particular, the amount of integrated discharge current is a time-integrated value of the discharge current from the condition of full-charge of the battery, that is, calculation of the total real capacity only necessitates the battery being fully charged.

Beneficially, the total real capacity is calculated as

$$\text{total real capacity} = (S1/(S1-S2)) \times X$$

wherein 'S1' is a first relative capacity of a battery in the condition of full-charge, 'S2' is a second relative capacity corresponding to said open voltage obtained from said battery in said no-load condition, and 'X' is the amount of integrated discharge current.

According to a still further preferred embodiment, charging to the battery is simultaneously controlled such that said relative capacity approximates to a middle value.

Therein, a current supply to the battery from an electric motor might be controlled, wherein the battery supplies electric power to the electric motor and is also supplied with regenerative electric power from the electric motor for charging.

According to yet another preferred embodiment, said total real capacity is calculated as

$$\text{total real capacity} = (100/(S1-S2)\times X)$$

wherein 'S1' is a first relative capacity corresponding to said open voltage obtained from said battery in the condition of no-load, 'S2' is a second relative capacity corresponding to said open voltage subsequently obtained from said battery in the condition of no-load, and 'X' is an amount of integrated discharge current discharged during the time that said first relative capacity S1 and said second relative capacity S2 are obtained.

For all of the above embodiments, it is beneficial if said open voltage is a value when said no-load condition continues for a predetermined time.

Moreover, it is further beneficial if the voltage and discharging current values are compensated with a temperature of the battery.

It is also further beneficial if said total real capacity is compared with a predetermined threshold, and if said total real capacity is no larger than said predetermined threshold, information is outputted that said battery is deteriorated.

Additionally, it might still be preferable if said battery is a secondary battery, in particular a lithium-ion battery.

According to the apparatus aspect, the objective is solved by a device for controlling a capacity of a battery comprising a no-load detection means for detecting a no-load condition of the battery, a voltage detection means for detecting a voltage of said battery in a no-load condition detected by said no-load detection means, a relative capacity detection means for detecting, from said voltage, a relative capacity of said battery corresponding to the voltage in advance, an amount-of-integrated discharge current calculation means for calculating an amount of integrated discharge current and a total real capacity calculation means for calculating a total real capacity of said battery based on said relative capacity and said amount of integrated discharge current.

Therein, it is preferable if the amount-of-integrated discharge current calculation means is adapted to calculate the amount of integrated discharge current by time-integration of the discharge current of said battery during the time of a load condition before said no-load condition is reached.

It is further preferable if a full-charge detection means for detecting the condition of full-charge of said battery is provided, wherein said amount-of-integrated discharge current calculation means is adapted to integrate a discharge current of said battery, from its full-charge condition, detected by said full-charge detection means.

Beneficially, said total real capacity is calculated as

$$\text{total real capacity} = (S1/(S1-S2)\times X)$$

wherein 'S1' is a first relative capacity of a battery in the condition of full-charge, 'S2' is a second relative capacity detected by said relative capacity detection means, and 'X' is said amount of integrated discharge current.

According to a preferred embodiment of the device, a charging control means is provided for controlling charging to the battery such that said relative capacity approximates to a middle value.

Therein, it is beneficial if said battery is adapted to supply electric power to an electric motor and is also adapted to be supplied with regenerative electric power from said electric motor for charging, and said charging control means is adapted to control current supply to said battery from said electric motor.

Therein, it is further beneficial if said total real capacity calculation means calculates said total real capacity as

$$\text{total real capacity} = (100/(S1-S2)\times X),$$

wherein 'S1' is a first relative capacity detected by said relative capacity detection means, 'S2' is a second relative capacity subsequently detected by said relative capacity detection means, and 'X' is an amount of integrated discharge current discharged during the time that said first relative capacity S1 and said second relative capacity S2 are obtained.

For all of the above embodiments directed to the present device for controlling a capacity of a battery, it is preferable if said voltage detection means detects a voltage when said no-load condition continues for a predetermined time.

It is further preferable if a table storage means for storing said voltage and said relative capacity as a table is provided, and said relative capacity detection means obtains said relative capacity corresponding to said voltage, based on said table stored in said table storage means.

It is still further preferable if a battery deterioration detection means for comparing said total real capacity with a predetermined threshold and for outputting information that said battery is deteriorated, if said total real capacity is no larger than said predetermined threshold, is provided.

Further, it is preferred that a battery temperature detection means is provided, which is adapted to detect a temperature of the battery and to compensate the voltage and discharging current values with respect to the temperature of the battery.

It is a further objective to provide a capacity control device of a battery for vehicle power also capable of easily determining a total real capacity of the battery subjected to repeated charging and discharging.

This objective is solved by a capacity control device of a battery for vehicle power having a device for controlling a capacity of a battery as has been discussed above, wherein said no-load detection means is adapted to detect said battery as being in a no-load condition when the vehicle is stopped continuously for a predetermined time.

In the following, the present invention is explained in greater detail with respect to several embodiments thereof in conjunction with the accompanying drawings, wherein:

Fig. 1    is a block diagram, showing the construction of a battery capacity control device according to a first embodiment;

Fig. 2A   is a table showing a relation between the relative capacity and the open voltage;

Fig. 2B   is a characteristic diagram, showing a relation between the relative capacity and the open voltage;

Fig. 3    is a characteristic diagram, showing change in characteristics at each time of charging and discharging, in the relation between the relative capacity and the open voltage;

Fig. 4    are characteristic diagrams for use in a procedure of calculating a total real capacity from an open voltage; (A) is a characteristic diagram, showing a relation between the relative capacity and the open voltage, and (B) is a characteristic diagram, showing a relation between the relative capacity obtained and the total real capacity;

Fig. 5    is a flowchart, showing a processing procedure by the battery capacity control device;

Fig. 6    is a characteristic diagram, showing change of the open voltage with the elapsed time after discharging stop.

Fig. 7    is a block diagram, showing the construction of a battery capacity control device according to a second embodiment;

Fig. 8    is a flowchart, showing a processing procedure by the battery capacity control device of the second embodiment, or a processing procedure for controlling the battery capacity to a constant value; and

Fig. 9    is a flowchart showing a processing procedure by the battery capacity control device of the second embodiment, or a processing procedure for determining the total real capacity of a battery.

Now, embodiments will be described in detail with reference to the drawings. A first embodiment is a battery capacity control device for controlling a capacity of a battery used for a power source of a motor-driven or power-assisted vehicle or a hybrid one.

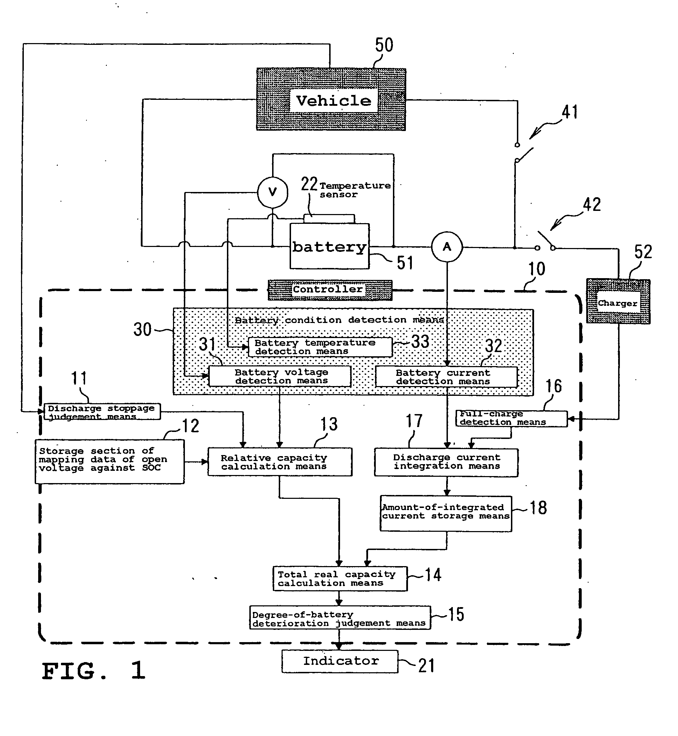

As shown in Fig. 1, a vehicle 50 carries a battery 51 consisting of a lithium-ion battery as a secondary battery, and a charger 52, and to the battery 51 and the charger 52 is connected a battery capacity control device.

The battery capacity control device comprises a controller 10, an indicator 21 and a temperature sensor 22.

The controller 10 is arranged such that it controls sections of the battery capacity control device. Specifically, as shown in Fig. 1, the controller 10 comprises battery condition detection means 30, discharging stop judgement means 11, storage means 12, relative capacity calculation means 13, total real capacity calculation means 14, degree-of-battery deterioration judgement means 15, full-charge detection means 16, discharge current integration means 17 and amount-of-integrated discharge current storage means 18.

The battery condition detection means 30 has a structure for detection of the condition of the battery 51, and specifically comprises battery voltage detection means 31, battery current detection means 32 and battery temperature detection means 33. The battery voltage detection means 31 detects the voltage of the battery 51; the battery current detection means 32 detects the charging and discharging current of the battery 51; and the battery temperature detection means 33 detects the temperature of the battery 51 through the temperature sensor 22. The battery condition detection means 30 compensates these voltage and discharging current values with respect to temperature using the temperature of the battery 51 obtained by the battery temperature detection means 33. Also, the battery condition detection means 30 outputs a voltage value to the relative capacity calculation means 13, and a discharging current value to the discharge current integration means 17.

The discharging stop judgement means 11 judges discharging of the battery 51. Specifically, the discharging stop judgement means 11 judges discharging stop of the battery 51 from the stopping condition of the vehicle. The discharging stop judgement means 11 outputs the judgement result to the relative capacity calculation means 13.

The relative capacity calculation means 13 calculates a relative capacity SOC of the battery 51 based on the voltage value of the battery 51 obtained by the battery condition detection means 30. The relative capacity SOC (%) of the battery 51 is calculated, based on the terminal voltage (open voltage) of the battery 51 during the time of no-load condition.

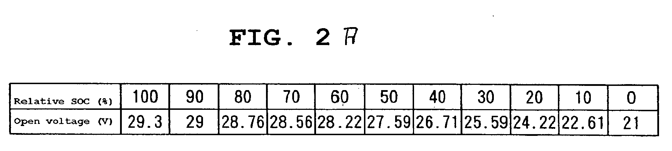

Here, the characteristics of a lithium-ion battery are shown. Fig. 2A is a table showing a relation between the relative capacity SOC and the open voltage.

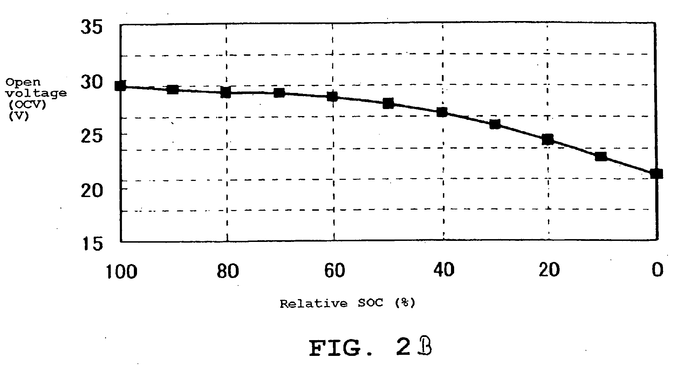

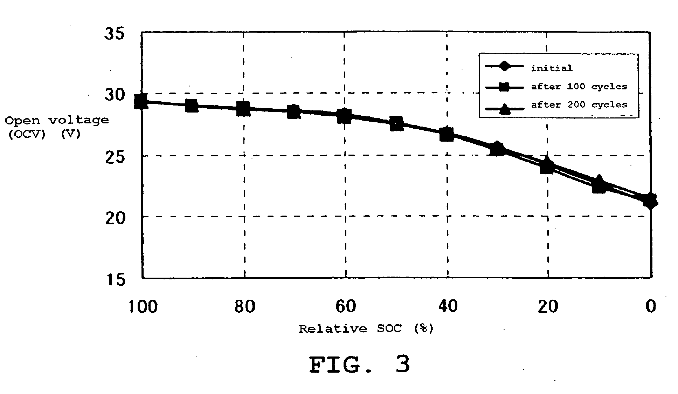

Fig. 2B shows a relation between the open voltage and the relative capacity SOC, with the horizontal axis representing relative capacity SOC and the vertical axis representing open voltage (OCV). Also, as shown in Fig. 3, comparison between a result in the initial condition, a result after 100 cycles of charging and discharging, and a result after 200 cycles of charging and discharging shows that the relation between the relative capacity SOC and the open voltage is maintained regardless of charging and discharging. In this embodiment, the relative capacity SOC is determined from the open voltage utilizing the characteristics of the lithium-ion battery, that is, the relation between the open voltage and the relative capacity SOC which is constant regardless of the number of charging and discharging cycles.

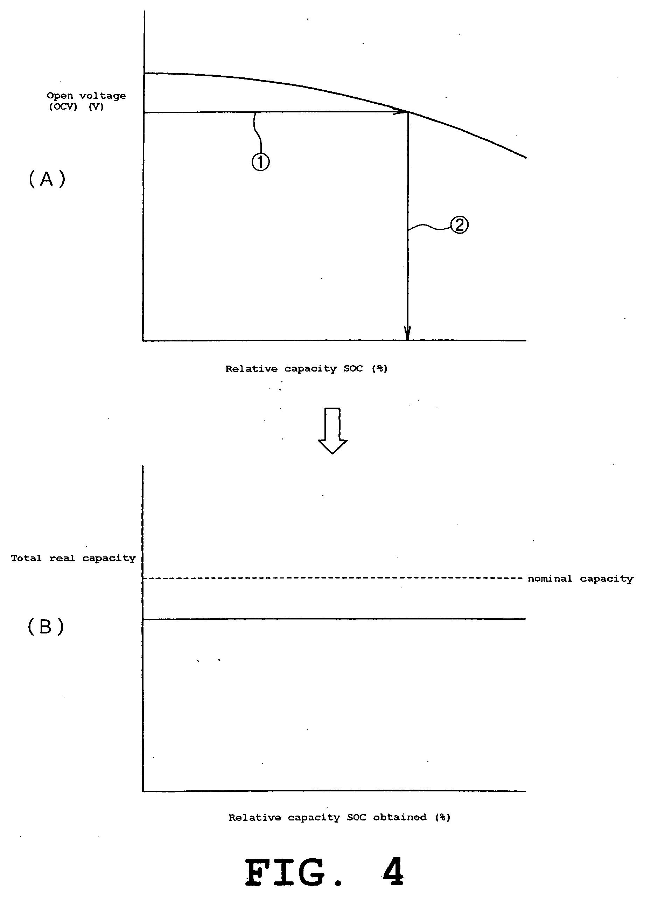

The relative capacity calculation means 13 determines a relative capacity SOC from an open voltage, based on such characteristics (or such tables). For example, Fig. 4 (A) shows a procedure of its derivation, and the relative capacity (2), corresponding to the open voltage (1), is obtained from the relation between the open voltage and the relative capacity as described above.

Specifically, the relative capacity can be obtained from the relation between the open voltage and the relative capacity as follows.

For example, the characteristic diagram shown in Fig. 2B is provided as a table made up of discrete data as exemplified in Fig. 2A. The table is stored in the storage means 12 as a mapping data. Values not contained in the table are determined by interpolation using the following expression (1):

$$\text{Relative capacity SOC to be found} = (SOC_{n+1} - SOC_n)$$

$$\times (V - V_n)/(V_{n+1} - V_n) + SOC_n \tag{1},$$

where n is any assigned positive. For example, supposing that an open voltage of 28 not contained in the table is obtained (as shown in Fig 4A), while for the data in the table having values before and after the open voltage thus obtained, $V_n = 27.95$ at $SOC_n = 40$ and $V_{n+1} = 28.22$ at $SOC_{n+1} = 60$ are predetermined. In this case, the relative capacity SOC is calculated from the expression (1) as follows.

$$\text{Relative capacity SOC to be found} = (60 - 50)$$

$$\times (28 - 27.95)/(28.22 - 27.95) + 50.$$

According to this expression, if open voltage V = 28, the relative capacity SOC to be found amounts to 56.5.

The full-charge detection means 16 detects whether or not the battery 51 is in the condition of full-charge by the charger 52. The full-charge detection means 16 outputs the detection result to the discharge current integration means 17.

The discharge current integration means 17 obtains an amount of integrated discharge current X based on a detection signal from the full-charge detection means 16 and battery current detection means 32. Specifically, the discharge current integration means 17 integrates the discharge current detected by the battery current detection means 32 after detection of full-charge by the full-charge detection means 16, to determine the amount of integrated discharge current X. The discharge current integration means 17 outputs the amount of integrated discharge current to the amount-of-integrated discharge current storage means 18, and the amount-of-integrated discharge current storage means 18 stores the amount of integrated discharge current X.

The total real capacity calculation means 14 calculates a total real capacity (total capacity) from the relative capacity SOC by the relative capacity calculation means 13, and the amount of integrated discharge current X stored by the amount-of-integrated discharge current storage means 18. Specifically, the total real capacity $T_{soc}$ is determined from the following expression (2):

$$\text{Total real capacity } T_{soc} = (100/(100-SOC))\times X \tag{2}.$$

The total real capacity calculation means 14 outputs the obtained total real capacity $T_{soc}$ to the degree-of-battery deterioration judgement means 15. Here, "100" (%) is a first relative capacity S1 of the battery in the condition of full-charge, and the relative capacity SOC is a second relative capacity S2 corresponding to the open voltage obtained from the battery 51 in a no-load condition.

The degree-of-battery deterioration judgement means 15 compares a nominal capacity of the battery 51 with the total real capacity $T_{soc}$ and judges whether or not the battery 51 is deteriorated. Specifically, the degree-of-battery deterioration judgement means 15 judges the battery 51 to be deteriorated if the total real capacity $T_{soc}$ is no larger than a nominal capacity. When the battery 51 is deteriorated, for example as shown in Fig. 4(B), the total real capacity becomes smaller than the nominal capacity for all the obtained relative capacity SOC, and the battery 51 is judged to be deteriorated from the foregoing relation.

A judgement that the battery 51 is deteriorated, is not limited when the total real capacity $T_{soc}$ is no larger than the nominal capacity, and the battery 51 may be judged to be deteriorated, for example, if the total real capacity $T_{soc}$ is no larger than a given value. Here, the given value is, for example, a value of some tens of percentage (for example, 80%) of the nominal capacity or a value of some tens of percentage of the initial capacity.

The controller 10 controls the indicator, based on the judgement result of the degree-of-battery deterioration judgement means 15, for external indication of whether or not the battery 51 is deteriorated.

Between the vehicle 50, battery 51 and charger 52, are disposed switches 41, 42 as appropriate so that they are turned on/off as appropriate in response to charging and discharging of the battery 51.

In the foregoing arrangement, the discharging stop judgement means 11 constitutes a no-load detection means for detecting the no-load condition of the battery; the battery voltage detection means 31 constitutes a voltage detection means for detecting the voltage of the battery in the no-load condition detected by the no-load detection means; the relative capacity calculation means 13 constitutes a relative capacity detection means for detecting, from a voltage, a relative capacity of the battery corresponding to the voltage in advance; the discharge current integration means 17 constitutes an amount-of-integrated discharge current calculation means for calculating the amount of integrated discharge current obtained by time-integration of the discharging current of the battery during the time of a load condition before a no-load condition is reached; and the total real capacity calculation means constitutes a total real capacity calculation means for calculating the total real capacity of the battery based on the relative capacity and the amount of integrated discharge current. Also, the full-charge detection means 16 constitutes a full-charge detection means for detecting the full-charge condition of the battery; the storage means 12 constitutes a table storage means for storing the voltage and the relative capacity as a table; and the degree-of-battery deterioration judgement means 15 constitutes a battery deterioration detection means for comparing the total real capacity with a given threshold and for outputting information that the battery is deteriorated if the total real capacity is no larger than the given threshold.

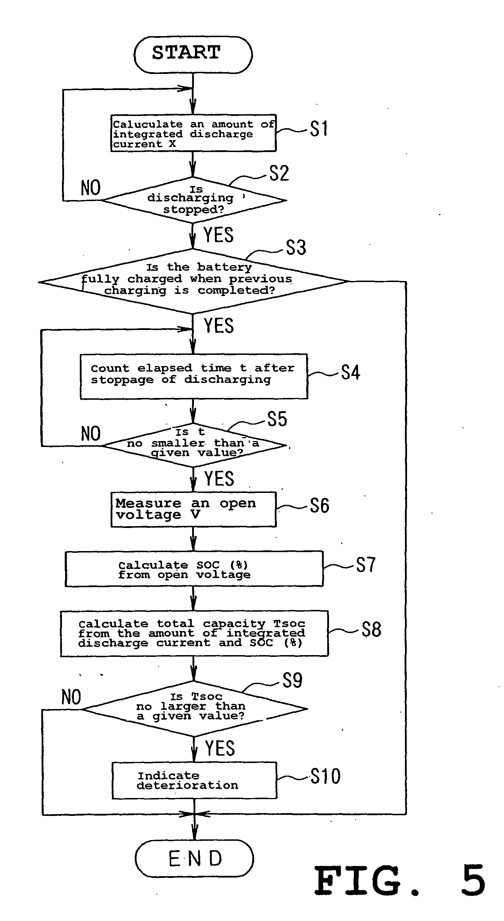

Fig. 5 shows a flowchart of processing performed by the components of the controller 51.

First, at step S1, the discharging current detected by the battery current detection means 32 is integrated by the discharge current integration means 17, and this integration continues until discharging stop is detected at the next step S2. For example, detection of the discharging stop is performed by reference to the detection of the stopping condition of the vehicle by the discharging stop judgement means 11. The amount of integrated discharge current X integrated until the detection of the discharging stop, is stored by the amount-of-integrated discharge current storage means 18.

If the discharging stop is detected at step S2, the full-charge detection means 16 judges whether or not the battery is fully charged in the previous charging. If the battery is judged to be fully charged in the previous charging, procedure proceeds to step S4, and if not, the processing shown in Fig. 5 is finished.

At the step S4, the discharging stop judgement means 11 counts the stoppage time of discharging, that is, elapsed time (duration) t of stoppage of the vehicle , and at the next step S5, it is judged that the elapsed time t is no smaller than a given value or not.

In particular, the embodiment may be structured such that at the step S5 the elapsed time t after the stoppage of discharging is counted until the counted elapsed time t becomes no smaller than a given value.

If the elapsed time t of the stoppage of the vehicle becomes no smaller than the given value at the step S5, procedure proceeds to step S6.

At the step S6, the battery voltage detection means 31 measures an open voltage V, and at the next step S7, the relative capacity calculation means 13 calculates a relative capacity SOC from the measured open voltage V using the foregoing table and the expression (1).

At step S8, the total real capacity calculation means 14 calculates a total real capacity $T_{soc}$ according to the expression (2), based on the relative capacity SOC and the amount of integrated discharge current X stored by the amount-of-integrated discharge current storage means 18.

Then, at step S9, it is judged that the total real capacity $T_{soc}$ is no larger than a given value (nominal capacity) or not, and if the total real capacity $T_{soc}$ is no larger than the given value (nominal capacity), the processing shown in Fig. 5 is finished. If not, procedure proceeds to step S10, where the indicator 21 indicates that the battery is deteriorated, and the processing shown in Fig. 5 is finished.

As described above, the judgement that the battery 51 is deteriorated, may by one that the battery 51 is deteriorated if the total real capacity $T_{soc}$ is no larger than a given value.

Operations of the battery capacity control device are as follows.

The battery capacity control device integrates the discharge current of the battery 51 until discharging stop is detected, to obtain the amount of integrated discharge current X (the step S1). The battery capacity control device detects the discharging stop (the step S2) and if the previous charging is a full-charge (the step S3), measurement of an open voltage V is performed (the step S6) after the discharging stop continues for a given time (the step S4 and step S5). If discharge is detected again before a given elapsed time, the processing may be finished.

The battery capacity control device determines a relative capacity SOC based on the measured open voltage V (the step S7), and a total real capacity $T_{soc}$ based on the relative capacity SOC and the amount of integrated discharge current X previously obtained (the step S8). If the total real capacity $T_{soc}$ is smaller than the nominal capacity, the indicator 21 indicates that the battery 51 is deteriorated (the step S9 and step S10).

Now, the effect of this embodiment is explained.

As described above, the battery capacity control device is able to determine a total real capacity of the battery 51 subjected to repeated charging and discharging, and to detect deterioration of the battery 51, based on the obtained total real capacity.

Also, the battery capacity control device, provided that the battery 51 is in full-charge as described above, determines a total real capacity based on an amount of integrated current after the full-charge. Thus, the battery capacity control device realizes determination of the total real capacity without need of the battery 51 being completely discharged.

Regarding a relation (SOC) between the open voltage and the relative capacity, the relative capacity is uniquely determined by the open voltage after discharging, as shown in Fig. 3, and this relation doesn't change even when charging and discharging are repeated, as shown in Fig. 4. Therefore, in this embodiment, a relative capacity is determined from an open voltage utilizing the forgoing characteristics, so that the total capacity is determined easily and with high accuracy.

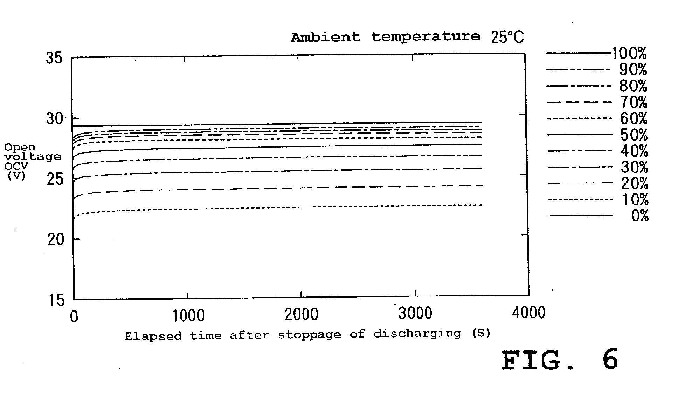

In addition, Fig. 6 shows change of the open voltage V with the elapsed time after discharging stop, with the horizontal axis representing the elapsed time after discharging stop, and the vertical axis the open voltage V during no-load condition after discharging. As shown in this relation, the open voltage V is settled to a fixed value or stabilized in a short time, and the open voltage V for the relative capacity SOC is determined utilizing such a relation (steps S4-S6), so that the total real capacity can be determined with high accuracy.

Further, the battery capacity control device outputs information on deterioration of the battery obtained, based on the total real capacity determined in this way. Thus, a driver is provided with information on deterioration of the battery, based on an accurate total real capacity, as useful information.

Since the phenomenon of deterioration of the battery over time is one that can be seen over a long period of time, battery control according to the procedure of Fig. 5 as described above, may be performed in cycles of a relatively long period of time. Alternatively, it may be performed in cycles of a relatively short period of time, and only when deterioration of the battery changes more rapidly than before, this information may be outputted.

Now, a second embodiment will be described.

The second embodiment is characterized by a battery capacity control device capable of providing optimum capacity control of a battery used for a power source of a motor-driven vehicle or a hybrid one, having a construction for determination of a total real capacity of the battery.

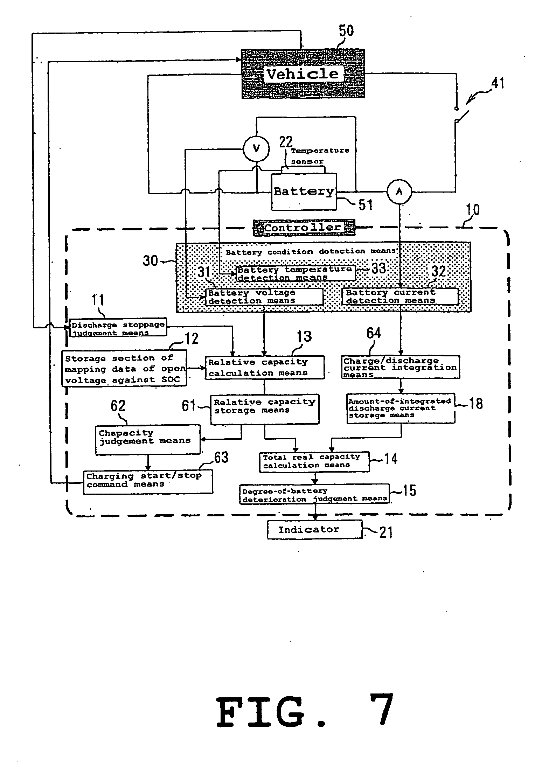

In the second embodiment, as in the first embodiment, a vehicle 50 carries a battery 51 consisting of a lithium-ion battery as a secondary battery, as shown in Fig. 7. To the battery 51 and the charger 52 is connected a battery capacity control device. Here, the battery 51 is arranged such that it supplies electric power to the vehicle 50 acting as an electric motor and is supplied with regenerative electric power from the vehicle 50 for charging.

The battery capacity control device in this second embodiment comprises a controller 10, an indicator 21 and a temperature sensor 22, as in the first embodiment. As shown in Fig. 7, the controller 10 comprises, in addition to the components in the first embodiment shown in Fig. 1, relative capacity storage means 61, capacity judgement means 62 and charging start/stop command means 63.

The relative capacity storage means 61 stores the relative capacity calculated by the relative capacity calculation means 13.

The capacity judgement means 62 judges the capacity, based on a relative capacity stored in the relative capacity calculation means 13. For example, capacity judgement is performed using a threshold of 50% or 60% as a relative capacity. The capacity judgement means 62 outputs the capacity judgement result to the charging start/stop command means 63.

The charging start/stop command means 63 outputs a charging start or a charging stop command to the vehicle 50, based on the capacity judgement result of the capacity judgement means 62. The charging start/stop command means 63 constitutes charging control means for controlling charging to the battery such that the relative capacity approximates to a middle value.

In the second embodiment, in place of the discharge current integration means 17 in the first embodiment, charge/discharge current integration means 64 is provided, which enables time-integration of the charging current.

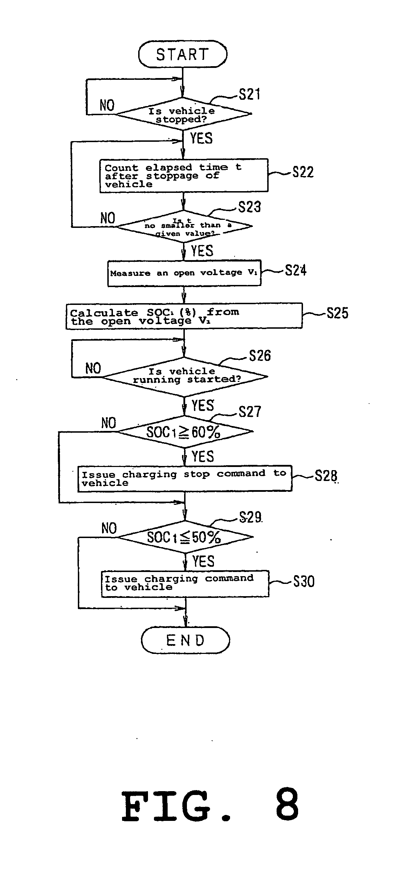

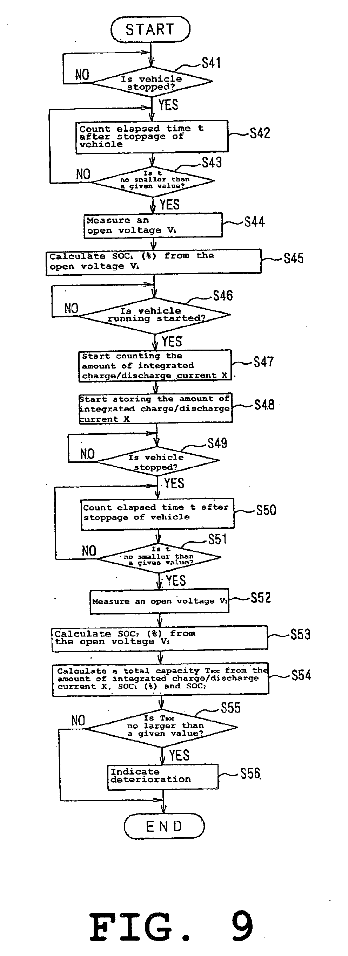

A processing procedure of the controller 10 arranged as described above, is shown in Fig. 8 and Fig.9.

First, the processing procedure of the controller 10 is explained with reference to Fig. 8. The processing shown in Fig. 8 is processing for controlling the battery capacity to a constant value.

First, stoppage of the vehicle is judged at step S 21. For example, detection of the stoppage of the vehicle is performed by referring to the detection of a discharging stop condition by the discharging stop judgement means 11.

If stoppage of the vehicle is detected at the step S21, an elapsed time (duration) t of stoppage of the vehicle is counted at the next step S22, and further it is judged at the next step S23 that the counted elapsed time t is no smaller than a given value or not. If the elapsed time t of stoppage of the vehicle becomes no smaller than the given value at step S23, procedure proceeds to step S24.

At the step S24, the battery voltage detection means 31 measures an open voltage $V_1$, and at the next step S25, the relative capacity calculation means 13 calculates a relative capacity $SOC_1$ from the measured open voltage $V_1$, using the foregoing table and the expression (1). The counted relative capacity $SOC_1$ is stored in the relative capacity storage means 61.

At the next step S26, it is judged that the vehicle starts running or not. For example, detection of running start of the vehicle is performed by referring to the detection of the condition of discharging stop by the discharging stop judgement means 11. That is, if discharging is started, running start of the vehicle is detected. If the running start of the vehicle is detected at the step S26, it is judged by the capacity judgement means 62 that the relative capacity $SOC_1$ stored in the relative capacity storage means 61 is no smaller than 60% or not, or it is no larger than 50% or not.

That is, at step S27, it is judged by the capacity judgement means 62 that the relative capacity $SOC_1$ stored in the relative capacity storage means 61 is no smaller than 60% or not. Here, if the relative capacity $SOC_1$ is no smaller than 60%, procedure proceeds to step S28, and if the relative capacity $SOC_1$ is smaller than 60%, procedure proceeds to step S29.

At the step S28, the charging start/stop command means 63 issues a charging stop command to the vehicle 50.

At the step S29, it is judged by the capacity judgement means 62 that the relative $SOC_1$ stored in the relative capacity storage means 61 is no larger than 50% or not. Here, if the relative capacity $SOC_1$ is no larger than 50%, procedure proceeds to step S30, and the charging start/stop command means 63 issues a charging command to the vehicle 50.

As described above, as a result of the processing at the steps S27-S30, a charging stop command is issued to the vehicle 50 if the relative capacity $SOC_1$ is no smaller than 60%, and a charging command (charging start command) is issued to the vehicle 50 if the relative capacity $SOC_1$ is no larger than 50%. After issuing such charging stop or charging start commands to the vehicle 50, the controller 10 finishes the processing shown in Fig. 8.

Now, the processing procedure of the controller 10 will be explained with reference to Fig. 9. The processing shown in Fig. 9 is processing for determining a total real capacity of a battery. The controller 10 determines the total real capacity, based on the relative capacity $SOC_1$ obtained in the processing shown in Fig. 8. That is, the processing shown at steps S31-S45 shown in Fig. 9, similar to the processing at the steps S21-S25 shown in Fig. 8, provides a relative capacity (hereinafter referred to as a first relative capacity). The first relative capacity $SOC_1$ is stored in the relative capacity storage means 61.

At step S46 shown in Fig. 9, it is judged that the vehicle running is started or not, as in the processing at the step S26 in Fig. 8. If running start of the vehicle is detected at the step S46, procedure proceeds to step S47.

At the step S47, count of the amount of integrated charge/discharge current X is started. Specifically, the charge/discharge current integration means 64 integrates the charge/discharge current detected by the battery current detection means 32. Specifically, the charge/discharge current charged or discharged after the timing $T_1$ at which the first relative capacity $SOC_1$ is detected, is integrated. The charge/discharge current is integrated, taking a current during discharging as a positive value and a current during charging as a negative value. That is, in this second embodiment, unlike the first embodiment, the battery 51 is charged by regenerative electric power from the vehicle 50, so that the amount of integrated discharge current is substantially obtained with the charge current taken into account.

At step S48, the amount of integrated charge/discharge current X obtained by the charge/discharge current integration means 64 is stored in the amount-of-integrated discharge current storage means 18. For example, the amount of integrated charge/discharge current X obtained at each sampling time is stored by superscription.

At the next step S49, stoppage of the vehicle is judged. For example, detection of the stoppage of the vehicle is performed by referring to the detection of the condition of discharging stop by the discharging stop judgement means 11.

If stoppage of the vehicle is detected at the step S49, an elapsed time (duration) t of stoppage of the vehicle is counted at the next step S50, and further it is judged at the next step S51 that the counted elapsed time t is no smaller than a given value or not. If the elapsed time t of stoppage of the vehicle becomes no smaller than the given value at step S51, procedure proceeds to step S52.

At the step S52, the battery voltage detection means 31 measures an open voltage $V_2$, and at the next step S53, the relative capacity calculation means 13 calculates a second relative capacity $SOC_2$ from the measured open voltage $V_2$, using the foregoing table and the expression (1). Here, the calculation of the second relative capacity $SOC_2$ is one at the timing $T_2$. The calculated second relative capacity $SOC_2$ is stored in the relative capacity storage means 61.

Then, at the next step S54, the total real capacity calculation means 14 calculates a total real capacity $T_{SOC}$ by the following expression (3), based on the first relative capacity $SOC_1$ and the second relative capacity $SOC_2$ stored in the relative capacity storage means 61, and the amount of integrated charge/discharge current X stored in the amount-of-integrated discharge current storage means 18.

As described above, at the step S47, count of the amount of integrated charge/discharge current X is started, and at the step S48, the amount of integrated charge/discharge current X obtained by the charge/discharge current integration means 64 is stored successively to the amount-of-integrated discharge current storage means 18. The count and the storage of the amount of integrated charge/discharge current X are performed until the time immediately before the processing of the step S53 or S54. That is, the amount of integrated charge/discharge current X used in the calculation at the step S54 is the value of charge/discharge current integrated by the timing T2 at which the second relative capacity $SOC_2$ is obtained.

$$\text{Total real capacity } T_{soc} = (100/(SOC_1 - SOC_2)) \times X \tag{3}$$

Then, at step S55, it is judged that the total real capacity $T_{soc}$ is no larger than a given value (nominal capacity), and if it is no larger than the given value (nominal capacity), the processing shown in Fig. 9 is finished. If not, procedure proceeds to step S56, and indication of deterioration is performed by the indicator 21, followed by completion of the processing shown in Fig. 9.

As described above, regarding the judgement of deterioration of the battery 51, it may be judged that the battery 51 is deteriorated if the total real capacity $T_{soc}$ becomes no large than a given value.

Operations of the battery capacity control device are as follows.

The battery capacity control device measures an open voltage $V_1$ (the step S24) after stoppage of the vehicle is detected and a given time has elapsed after the stoppage (the steps S21, S22 and S23), and further determines a relative capacity $SOC_1$ based on the measured open voltage $V_1$ (the step S25).

Also, if the vehicle 50 starts running (the step S25), the battery capacity control device outputs a charging stop or charging start command to the vehicle 50, based on the relative capacity $SOC_1$ (the steps S27-S30). Specifically, a charging stop command is issued to the vehicle 50 if the relative capacity $SOC_1$ is no smaller than 60% (the steps S27 and S28), and a charging start command is issued to the vehicle 50 if the relative capacity $SOC_1$ is no larger than 50% (the steps S29 and S30). This restricts charging by the vehicle 50, and the battery capacity is controlled within the range of 50%-60% as viewed in relative capacity $SOC_1$.

As described above, the battery capacity control device controls the battery capacity to a constant value. On the other hand, the battery capacity control device performs processing for determining the total real capacity of the battery 51.

That is, the battery capacity control device obtains the first relative capacity $SOC_1$ (the steps S41-S45), starts counting the amount of integrated charge/discharge current X (the step S47) if running start of the vehicle is detected (the step S46), and stores the amount of integrated charge/discharge current X successively (the step S48).

Then, the battery capacity control device measures an open voltage $V_2$ (the step S52) after stoppage of the vehicle is detected and a given time has elapsed after the stoppage (the steps S49-S51), and further determines a second relative capacity $SOC_2$ based on the measured open voltage $V_2$ (the step S53).

The battery capacity control device determines a total real capacity $T_{soc}$ (the step S54) based on the second relative capacity $SOC_2$, the first relative $SOC_1$ previously determined, and the amount of integrated charge/discharge current X (amount of integrated charge/discharge current X obtained at the measurement timing $T_2$ of the second relative capacity $SOC_2$) stored in the amount-of-integrated discharge current storage means 18. If the total real capacity

$T_{soc}$ is smaller than a normal capacity, the indicator 21 indicates that the battery 51 is deteriorated (the steps S55 and S56).

Now, the effect of the second embodiment will be described.

As described above, charging of the vehicle 50 is controlled so that the battery capacity is maintained within the range of 50%-60% in relative capacity $SOC_1$.

In a hybrid vehicle, in order that the battery is allowed to receive regenerative electric power from the vehicle (electric motor) and further, electric power can be supplied from the battery to the vehicle (electric motor) if required, the battery capacity is preferably controlled such that it approximates to a middle value (50%-60%) between the condition of full-charge (100%) and the condition of no-charge (0%).

Thus, according to this embodiment, if the battery capacity is controlled within the range of 50%-60% in relative capacity $SOC_1$, the battery capacity can be controlled such that the battery 51 is allowed to receive regenerative electric power from the vehicle (electric motor) 50 and further, electric power can be supplied from the battery 51 to the vehicle (electric motor) 50 if required.

In addition, while the battery capacity is controlled as described above, determination of the total real capacity is also effected in this embodiment.

Further, in calculating the total real capacity, the calculation is effected without need of full-charge. As described above, while the battery capacity is preferably maintained in a condition in which electric power can be supplied from the battery to the vehicle (electric motor) if required, this embodiment satisfies this demand and at the same time, realizes the calculation of the total real capacity.

Further, although in the foregoing first embodiment, calculation of the total real capacity is performed on the premise of full-charge, that doesn't satisfy a condition as the foregoing demand such that the battery is allowed to receive regenerative electric power. In the second embodiment, however, the total real capacity can be determined without the premise of full-charge, as shown in the expression (3), which satisfies the demand for the battery to be allowed to receive regenerative electric power and at the same time, enables determination of the total real capacity.

Further, the second embodiment also has the same effect as the first embodiment. That is, regarding a relation between the open voltage and the relative capacity, the relative capacity is uniquely determined by the open voltage after discharging, as shown in Fig. 3, and this relation doesn't change even when charging and discharging are repeated, as shown in Fig. 4. In this invention, a relative capacity is determined from an open voltage utilizing the forgoing characteristics, so that the total capacity can be determined easily and with high accuracy.

Further, as shown in the relation of Fig. 6, since the open voltage is settled to a fixed value or stabilized in a short time, if the open voltage to find the relative capacity SOC is determined utilizing such a relation, the total real capacity can be determined with high accuracy.

Also, the battery capacity control device outputs information on deterioration of the battery obtained, based on the total real capacity determined in this way. Thus, a driver is provided with information on deterioration of the battery, based on an accurate total real capacity, as useful information.

While this invention has been described in its embodiments, it is to be understood that this invention is not limited to the foregoing embodiments.

The foregoing embodiments are exemplified by capacity control of a lithium-ion battery as a secondary battery, but the teaching may be applied to the capacity control of other batteries. That is, the capacity of a battery can be controlled by a capacity control device embodying this teaching, if only the battery is one in which a relative capacity is uniquely determined by a voltage.

Also, the foregoing embodiments are exemplified by capacity control of a battery for vehicle power, but this teaching may be applied to the capacity control of other batteries than a battery for vehicle power.

Also, in the foregoing embodiments, means for controlling the capacity of the battery 51 may be provided as software programs.

The description above discloses (amongst others) a battery capacity control method, wherein a relation is utilized in which a relative capacity of a battery can be uniquely determined from an open voltage of the battery after discharging, so as to determine said relative capacity corresponding to said open voltage obtained from said battery in a no-load condition, and a total real capacity of said battery is calculated, based on the relative capacity, and an amount of integrated discharge current of said battery obtained by time-integration during the time of a load condition before the no-load condition is reached.

Also, a battery capacity control device is disclosed comprising a no-load detection means for detecting a no-load condition of a battery; a voltage detection means for detecting a voltage of said battery in a no-load condition detected by said no-load detection means; a relative capacity detection means for detecting, from said voltage, a relative capacity of said battery corresponding to the voltage in advance; an amount-of-integrated discharge current calculation means for calculating an amount of integrated discharge current obtained by time-integration of the discharge current of said battery during the time of a load condition before said no-load condition is reached; and a total real capacity calculation means for calculating a total real capacity of said battery based on said relative capacity and said amount of integrated discharge current.

Thus, a relative capacity is determined corresponding to an open voltage obtained from a battery in a no-load condition, and a total real capacity is calculated, based on the relative capacity and an amount of integrated discharge current of said battery obtained by time-integration during the time of a load condition before no-load condition is reached.

Here, a relation is established in which a relative capacity of a battery is uniquely determined from an open voltage of the battery after discharging, therefore the relative capacity is obtained from the open voltage using this relation, and the total real capacity is calculated, based on the relative capacity.

As the relation is utilized in which a relative capacity of a battery is uniquely determined by an open voltage after discharging of the battery, so as to obtain the relative capacity from the open voltage, and a total real capacity is calculated, based on the relative capacity, so that the total real capacity can be calculated easily and with high accuracy.

With regard to the battery capacity control method, it is further disclosed that said amount of integrated discharge current may be a time-integrated value of the discharge current discharged from the condition of full-charge of said battery.

Regarding the battery capacity control device, it is further disclosed that said device comprises full-charge detection means for detecting the condition of full-charge of said battery, and said amount-of-integrated discharge current calculation means integrates discharge current of said battery, from its full-charge condition, detected by said full-charge detection means.

Thus, the amount of integrated discharge current is a time-integrated value of the discharge current from the condition of full-charge of the battery, that is, calculation of the total real capacity only necessitates the battery being fully charged.

As calculation of the total real capacity only necessitates a battery being fully charged, the total real capacity can be calculated without need of time and labor of complete discharging.

With regard to the battery capacity control method, charging to the battery is simultaneously controlled such that said relative capacity approximates to a middle value.

Regarding the battery capacity control device, a charging control means is provided for controlling charging to the battery such that said relative capacity approximates to a middle value.

Therefore, while charging to the battery is controlled such that a relative capacity of the battery approximates to a middle value, a total real capacity is calculated, based on this relative capacity value.

Further, while charging to the battery is controlled such that a relative capacity of the battery approximates to a middle value, a total real capacity is calculated, based on this relative capacity value. This enables power supply from the battery and charging to the battery by regenerative electric power, as well as calculation of the total real capacity based on the relative capacity.

The battery capacity control method as discussed above may include controlling current supply to said battery from an electric motor, wherein said battery supplies electric power to said electric motor and is also supplied with regenerative electric power from said electric motor for charging.

Within the battery capacity control device, said battery may supply electric power to said electric motor and may be supplied with regenerative electric power from said electric motor for charging, and said charging control means controls current supply to said battery from said electric motor.

Therefore, electric power is supplied to the electric motor, and the relative capacity of the battery supplied with regenerative electric power from the electric motor for charging is controlled such that it approximates to a middle value.

As discussed for the battery capacity control method, said total real capacity may be compared with a predetermined threshold, and if said total real capacity is no larger than said predetermined threshold, information may be outputted that said battery is deteriorated.

As discussed for the battery capacity control device, said device may comprise a battery deterioration detection means for comparing said total real capacity with a predetermined threshold and for outputting information that said battery is deteriorated, if said total real capacity is no larger than said predetermined threshold.

Thus, information that the battery is deteriorated, is outputted, based on the total real capacity.

Furthermore, stoppage time of a vehicle is measured to detect the no-load condition of the battery, and it is determined to be a no-load condition when the vehicle is stopped continuously for a given time.

Furthermore, information that the battery is deteriorated, is outputted, based on a total real capacity, so that a user can be provided with useful information on the condition of a battery.

The description above further discloses for an embodiment of the battery capacity control method that if a first relative capacity of a battery in the condition of full-charge is represented by S1, a second relative capacity corresponding to said open voltage obtained from said battery in said no-load condition by S2, and said amount of integrated discharge current by X, said total real capacity is calculated as

$$\text{total real capacity} = (S1/(S1-S2)\times X).$$

However, it is also disclosed for another embodiment of the battery capacity control method that if a first relative capacity corresponding to said open voltage obtained from said battery in the condition of no-load is represented by S1, a second relative capacity corresponding to said open voltage subsequently obtained from said battery in the condition of no-load by S2, and an amount of integrated discharge current discharged during the time that said first relative capacity S1 and said second relative capacity S2 are obtained, by X, said total real capacity is calculated as

$$\text{total real capacity} = (100/(S1-S2)\times X).$$

Further, it is disclosed that said open voltage may be a value when said no-load condition continues for a predetermined time.

Moreover, it is disclosed that said battery may be a secondary battery, in particular said secondary battery may be a lithium-ion battery.

For an embodiment of the battery capacity control device, if a first relative capacity of a battery in the condition of full-charge is represented by S1, a second relative capacity detected by said relative capacity detection means by S2, and said amount of integrated discharge current by X, said total real capacity is calculated as

$$\text{total real capacity} = (S1/(S1-52)\times X).$$

However, for another embodiment of the battery capacity control device, if a first relative capacity detected by said relative capacity detection means is represented by S1, a second relative capacity subsequently detected by said relative capacity detection means, by S2, and an amount of integrated discharge current discharged during the time that said first relative capacity S1 and said second relative capacity S2 are obtained, by X, said total real capacity calculation means may also be adapted to calculate said total real capacity as

$$\text{total real capacity} = (100/(S1-S2)\times X).$$

It is also disclosed that said voltage detection means may detect a voltage when said no-load condition continues for a predetermined time.

Moreover, it is disclosed that said device may comprise a table storage means for storing said voltage and said relative capacity as a table, and said relative capacity detection means obtains said relative capacity corresponding to said voltage, based on said table stored in said table storage means.

The description above further discloses according to a preferred embodiment a capacity control device of a battery for vehicle power, wherein said device comprises a battery capacity control device as discussed above, and said no-load detection means detects said battery as being in a no-load condition when the vehicle is stopped continuously for a predetermined time.

Thus, a no-load condition of a battery can be detected by reference to the stoppage of a vehicle.

Accordingly, briefly summarizing the above, there is determined a total real capacity of a battery subjected to repeated charging and discharging by a battery capacity control device comprising discharging stop judgement means 11 for detecting a no-load condition of a battery; battery voltage detection means 31 for detecting an open voltage of the battery in a no-load condition detected by the discharging stop judgement means 11; relative capacity calculation means 13 for detecting, from an open voltage, a relative capacity SOC of the battery 51 corresponding to the open voltage in advance; discharge current integration means 17 for calculating an amount of integrated discharge current of the battery 51 during the time of a load condition before the no-load condition is reached; and total real capacity calculation means 14 for calculating a total real capacity of the battery 51 based on the relative capacity SOC and the amount of integrated discharge current.

**Claims**

1. Method for controlling a capacity of a battery, wherein a relative capacity is determined corresponding to an open voltage obtained from the battery in a no-load condition, and wherein a total real capacity is calculated based on the relative capacity and based on an amount of integrated discharge current of said battery.

**2.** Method for controlling a capacity of a battery according to claim 1, **characterized in that** the relative capacity of the battery is uniquely determined from the open voltage of the battery after discharging and/or the amount of integrated discharge current of said battery is obtained by time-integration during the time of a load condition before no-load condition is reached, wherein said amount of integrated discharge current, preferably, is a time-integrated value of the discharge current discharged from the condition of full-charge of said battery.

**3.** Method for controlling a capacity of a battery according to claims 1 or 2, **characterized in that** the total real capacity is calculated as

$$\text{total real capacity} = (S1/(S1-S2) \times X),$$

wherein 'S1' is a first relative capacity of a battery in the condition of full-charge, 'S2' is a second relative capacity corresponding to said open voltage obtained from said battery in said no-load condition, and 'X' is the amount of integrated discharge current.

**4.** Method for controlling a capacity of a battery according to claim 1 or 2, **characterized in that** charging to the battery is simultaneously controlled such that said relative capacity approximates to a middle value.

**5.** Method for controlling a capacity of a battery according to claim 4, **characterized by** controlling a current supply to the battery from an electric motor, wherein the battery supplies electric power to the electric motor and is also supplied with regenerative electric power from the electric motor for charging.

**6.** Method for controlling a capacity of a battery according to claim 4 or 5, **characterized in that** said total real capacity is calculated as

$$\text{total real capacity} = (100/(S1-S2) \times X),$$

wherein 'S1' is a first relative capacity corresponding to said open voltage obtained from said battery in the condition of no-load, 'S2' is a second relative capacity corresponding to said open voltage subsequently obtained from said battery in the condition of no-load, and 'X' is an amount of integrated discharge current discharged during the time that said first relative capacity S1 and said second relative capacity S2 are obtained.

**7.** Method for controlling a capacity of a battery according to at least one of the preceding claims 1 to 6, **characterized in that** said open voltage is a value when said no-load condition continues for a predetermined time.

**8.** Method for controlling a capacity of a battery according to at least one of the preceding claims 1 to 7, **characterized in that** the voltage and discharging current values are compensated with a temperature of the battery.

**9.** Method for controlling a capacity of a battery according to at least one of the preceding claims 1 to 8, **characterized in that** said total real capacity is compared with a predetermined threshold, and if said total real capacity is no larger than said predetermined threshold, information is outputted that said battery is deteriorated.

**10.** Method for controlling a capacity of a battery according to at least one of the preceding claims 1 to 9, **characterized in that** said battery is a secondary battery, in particular a lithium-ion battery.

**11.** Device for controlling a capacity of a battery comprising a no-load detection means for detecting a no-load condition of the battery,
a voltage detection means for detecting a voltage of said battery in a no-load condition detected by said no-load detection means,
a relative capacity detection means for detecting, from said voltage,
a relative capacity of said battery corresponding to the voltage in advance,
an amount-of-integrated discharge current calculation means for calculating an amount of integrated discharge current and a total real capacity calculation means for calculating a total real capacity of said battery based on said relative capacity and said amount of integrated discharge current.

**12.** Device for controlling a capacity of a battery according to claim 11, **characterized in that** the amount-of-integrated discharge current calculation means is adapted to calculate the amount of integrated discharge current by time-integration of the discharge current of said battery during the time of a load condition before said no-load condition is reached.

13. Device for controlling a capacity of a battery according to claim 11 or 12, **characterized by** a full-charge detection means for detecting the condition of full-charge of said battery, wherein said amount-of-integrated discharge current calculation means is adapted to integrate a discharge current of said battery, from its full-charge condition, detected by said full-charge detection means.

14. Device for controlling a capacity of a battery according to claim 11 to 13, **characterized in that** said total real capacity is calculated as

$$\text{total real capacity} = (S1/(S1-S2) \times X),$$

wherein 'S1' is a first relative capacity of a battery in the condition of full-charge, 'S2' is a second relative capacity detected by said relative capacity detection means, and 'X' is said amount of integrated discharge current.

15. Device for controlling a capacity of a battery according to claim 11, **characterized by** a charging control means provided for controlling charging to the battery such that said relative capacity approximates to a middle value.

16. Device for controlling a capacity of a battery according to claim 15, **characterized in that** said battery is adapted to supply electric power to an electric motor and is also adapted to be supplied with regenerative electric power from said electric motor for charging, and said charging control means is adapted to control current supply to said battery from said electric motor.

17. Device for controlling a capacity of a battery according to claim 15 or 16, **characterized in that** said total real capacity calculation means calculates said total real capacity as

$$\text{total real capacity} = (100/(S1-S2) \times X),$$

wherein 'S1' is a first relative capacity detected by said relative capacity detection means, 'S2' is a second relative capacity subsequently detected by said relative capacity detection means, and 'X' is an amount of integrated discharge current discharged during the time that said first relative capacity S1 and said second relative capacity S2 are obtained.

18. Device for controlling a capacity of a battery according to at least one of the preceding claims 11 to 17, **characterized in that** said voltage detection means detects a voltage when said no-load condition continues for a predetermined time.

19. Device for controlling a capacity of a battery according to at least one of the preceding claims 11 to 18, **characterized by** a table storage means for storing said voltage and said relative capacity as a table, and said relative capacity detection means obtains said relative capacity corresponding to said voltage, based on said table stored in said table storage means.

20. Device for controlling a capacity of a battery according to at least one of the preceding claims 11 to 19, **characterized by** a battery deterioration detection means for comparing said total real capacity with a predetermined threshold and for outputting information that said battery is deteriorated, if said total real capacity is no larger than said predetermined threshold.

21. Device for controlling a capacity of a battery according to at least one of the preceding claims 11 to 20, **characterized by** a battery temperature detection means adapted to detect a temperature of the battery and to compensate the voltage and discharging current values with respect to the temperature of the battery.

22. Capacity control device of a battery for vehicle power having a device for controlling a capacity of a battery according to at least one of the preceding claims 11 to 21, and wherein said no-load detection means is adapted to detect said battery as being in a no-load condition when the vehicle is stopped continuously for a predetermined time.

FIG. 1

# FIG. 2 A

| Relative SOC (%) | 100 | 90 | 80 | 70 | 60 | 50 | 40 | 30 | 20 | 10 | 0 |
|---|---|---|---|---|---|---|---|---|---|---|---|
| Open voltage (V) | 29.3 | 29 | 28.76 | 28.56 | 28.22 | 27.59 | 26.71 | 25.59 | 24.22 | 22.61 | 21 |

FIG. 2B

FIG. 3

(A)

Open voltage
(OCV) (V)

①

②

Relative capacity SOC (%)

Total real capacity

nominal capacity

(B)

Relative capacity SOC obtained (%)

# FIG. 4

FIG. 5

**FIG. 6**

FIG. 7

FIG. 8

FIG. 9

24